Europäisches Patentamt

**European Patent Office**

**Office européen des brevets**

(19)

(11) Numéro de publication : **0 032 197**
**B1**

(12) **FASCICULE DE BREVET EUROPÉEN**

(45) Date de publication du fascicule du brevet :
11.04.84

(21) Numéro de dépôt : **80107638.1**

(22) Date de dépôt : **04.12.80**

(51) Int. Cl.³ : **G 01 R 31/28, H 01 L 21/66**

(54) **Procédés de test pour circuits intégrés à semi-conducteurs permettant la détermination électrique de certaines tolérances lors des étapes photolithographiques.**

(30) Priorité : 09.01.80 FR 8000751

(43) Date de publication de la demande :
22.07.81 Bulletin 81/29

(45) Mention de la délivrance du brevet :
11.04.84 Bulletin 84/15

(84) Etats contractants désignés :
DE FR GB

(56) Documents cités :
FR-A- 2 296 852
JOURNAL OF THE ELECTROCHEMICAL SOCIETY,
vol. 125, no. 4, avril 1978 Princeton US M.G. BUEHLER
et al.: "Bridge and Van der Pauw Sheet Resistors for
Characterizing the Line Width of Conducting Layers",
pages 650-654
IBM TECHNICAL DISCLOSURE BULLETIN, vol. 14,
no. 12, mai 1972, New York US T.H. BAKER et al.:
"Dumbbell-Type Resistance Testing Structure", page
3707
IEEE JOURNAL OF SOLID STATE CIRCUITS, vol. SC-
13, no. 4, août 1978 New York US D.S. PERLOFF: "A
Four-Point Electrical Measurement Technique for
Characterizing Mask Superposition Errors on Semiconductor Wafers", pages 436-444

(73) Titulaire : **International Business Machines Corporation**
**Old Orchard Road**
**Armonk, N.Y. 10504 (US)**

(72) Inventeur : **Cullet, René**
**39 bis, rue de la Forêt Macherin Saint Martin**
**en Biere F-77630 Barbizon (FR)**

(74) Mandataire : **Klein, Daniel Jacques Henri**
**Compagnie IBM France Département de Propriété**
**Industrielle**
**F-06610 La Gaude (FR)**

Procédés de test pour circuits intégrés à semi-conducteurs permettant la détermination
électrique de certaines tolérances lors des étapes photolithographiques

## Description

### Domaine Technique

La présente invention concerne le test et le contrôle des tranches semi-conductrices. Elle concerne plus particulièrement des procédés de test permettant la détermination électrique de certaines caractéristiques telles que les tolérances de dimensions d'images et de recouvrement, lors des étapes photolithographiques.

### Etat de la Technique

Il est bien connu que parmi les très nombreuses étapes de fabrication de circuits intégrés à semi-conducteurs (diffusion, épitaxie, métallurgie, etc...) les étapes de lithographie sont les plus importantes : d'abord parce qu'elles sont très fréquentes, (environ 10 étapes de masquage pour un MOSFET, environ 15 étapes de masquage pour un transistor bipolaire), ensuite parce qu'elles déterminent finalement la densité des circuits. La recherche d'une densité accrue, a développé considérablement ce domaine de la lithographie de l'exposition par radiations ultraviolettes, on est passé à l'exposition par faisceaux électroniques, et par des rayons X. En même temps que les procédés conduisaient à des résolutions de plus en plus fines (0,5 à 1 micron), ces étapes sont devenues plus critiques. En effet, il est bien connu que les couches de masquage (ou les masques) utilisés dans la fabrication des circuits intégrés, s'écartent des spécifications désirées par le concepteur de circuit, en raison de phénomènes non désirés, tels que la sur-exposition ou la sous-exposition des résines sensibles pendant la fabrication desdites couches de masquages (ou desdits masques). Egalement, on sait aussi que même si la couche de masquage (ou le masque) présente la largeur nominale d'une ligne désirée (W), un sur-décapage ou un sous-décapage de la couche isolante donne des régions diffusées qui sont soit trop larges, soit trop fines comparées à la largeur nominale (de conception). Des lignes réalisées avec des variations importantes de largeurs ($\Delta$W) par rapport à la largeur nominale (W) peuvent poser des problèmes de fiabilité dus, à des court-circuits ou circuits ouverts indésirables et doivent être par conséquent détectées aussitôt que possible durant le procédé de fabrication.

Une autre caractéristique importante est que les régions diffusées (résistances, lignes, capacités, ...) réalisées à travers une couche isolante gravée selon une configuration désirée susceptible de présenter des tolérances sur les dimensions, peuvent conduire à des composants de valeurs incorrectes et causer des problèmes lors du fonctionnement.

Il est donc important de maîtriser les défauts d'alignement et autres qui conduisent à des déplacements des images, ces déplacements ou variations ($\Delta$W) exprimant les tolérances de dimension : on recherche une gravure de largeur W, mais on obtient une gravure de largeur $\Delta$W + W ($\Delta$W étant positif ou négatif). La tolérance relative est définie par le rapport $\Delta$W/W.

Par ailleurs, il est souvent utile de connaître la tolérance de recouvrement ou d'alignement de deux images superposées, cette tolérance est habituellement mesurée et contrôlée visuellement, avec les mêmes inconvénients que ceux indiqués ci-dessus.

La référence FR-A-2 296 852 décrit un procédé et une structure de test pour la détermination de la tolérance de dimensions, par des mesures, qui dans certains cas, peuvent être essentiellement électriques. Ce procédé aboutit à une relation sous forme fractionnaire dont le numérateur est constitué par une différence de deux grandeurs relativement importantes. Ce procédé est donc très imprécis.

La référence « Bridge and Van der Paun Sheet Resistors for characterizing the line width of Conducting Layers », J.E.S. Vol. 125, n° 4, avril 1978, pages 650 à 654 se rapporte à un procédé et à des structures de test pour la détermination des largeurs de lignes conductrices. Le problème de la détermination des tolérances de dimensions n'est pas posé et encore moins résolu. Le document « A Four Point Electrical Measurement Technique for Characterizing Mask Superposition errors on S/C Wafers », IEEE, JSSC Vol. SC-13, n° 4, août 1978, pages 436-444 décrit un procédé et une structure de test pour la détermination des erreurs de superposition de masques sur les tranches semi-conductrices à partir de mesures de résistivité de feuille par la classique méthode des quatre points.

Enfin la référence publiée dans l'IBM Technical Disclosure Bulletin Vol. 14, n° 12, mai 1972, pages 3707-3708 intitulée : « Dembell Type Resistance Testing Structure », se rapporte à la détermination de la résistivité d'une région base d'un transistor, par la classique méthode des quatre points.

### Exposé de l'Invention

Un premier but de l'invention est de fournir des structures de test et des procédés de test qui permettent la détermination directe des tolérances de dimension d'image grâce à des mesures essentiellement électriques.

Un autre but de l'invention est de remplacer les procédés d'inspection visuelle, longs, coûteux et peu sûrs, par un procédé de test particulièrement approprié au test automatique qui permet de constituer très facilement des bases de données statistiques susceptibles de fournir, à la demande, des cartes de tranches mettant en évidence les blocs bons ou mauvais.

Encore un autre but de l'invention est de fournir des structures de test et un procédé de test qui en combinaison avec les précédents permettent la détermination électrique des tolérances de recouvrement ou d'alignement de deux images superposées.

La présente invention concerne donc en premier lieu un procédé de test selon la première revendication qui permet la détermination des tolérances de dimensions d'image à partir de mesures électriques. Les structures comprennent deux ponts de résistances intégrées dans un substrat semiconducteur typiquement en silicium, qui lorsqu'on injecte un courant selon une première diagonale permet de mesurer une différence de potentiel sur l'autre diagonale, respectivement $\Delta V1$ et $\Delta V2$ pour chaque pont de résistances. Les dimensions des résistances sont choisies de telle sorte que, la tolérance de dimensions soit reliée directement à ces tensions mesurées. Ainsi dans un mode de réalisation préféré, la tolérance de dimension $\Delta W$ est reliée aux grandeurs électriques $\Delta V1$ et $\Delta V2$ par une relation du genre

$$\frac{\Delta W}{W} = \frac{2 \; \Delta V2}{\Delta V1 - \Delta V2} \cdot$$

La présente invention concerne également l'application de ce procédé de test à la mesure des tolérances de recouvrement $\Delta A$ lors de la superposition de deux images, selon la revendication 4.

Les buts caractéristiques et avantages de la présente invention ressortiront mieux de l'exposé qui suit, fait en référence aux dessins annexés à ce texte, qui représentent un mode de réalisation préféré de celle-ci.

## Brève Description des Figures

La figure 1 représente la topologie d'un premier pont de résistances constituant une partie de la structure de test et de contrôle de la tolérance de dimension intégrée sur une tranche de silicium.

La figure 2 représente la topologie d'un deuxième pont de résistances constituant une autre partie de la structure de test et de contrôle de la tolérance de dimension intégrée sur une tranche de silicium.

La figure 3 représente une autre structure de test unique combinant en une seule topologie les deux ponts de résistance mentionnés précédemment.

La figure 4 représente la topologie du masque destiné à permettre la mesure de la tolérance de recouvrement et comportant deux configurations distinctes pour permettre cette mesure selon deux axes perpendiculaires.

La figure 5 représente la structure de test permettant de mesurer la tolérance de recouvrement, intégrée sur la tranche semi-conductrice après superposition des deux configurations montrées sur la figure 4.

## Description de l'Invention

La présente invention propose d'abord deux ponts de résistances qui permettent la détermination des tolérances sur les dimensions d'images qui sont dues aux étapes de lithographie, très nombreuses dans le cours du procédé de traitement des blocs semi-conducteurs.

Les dimensions des résistances sont choisies de telle sorte que la tolérance recherchée soit une fonction directe des tensions qui sont effectivement mesurées.

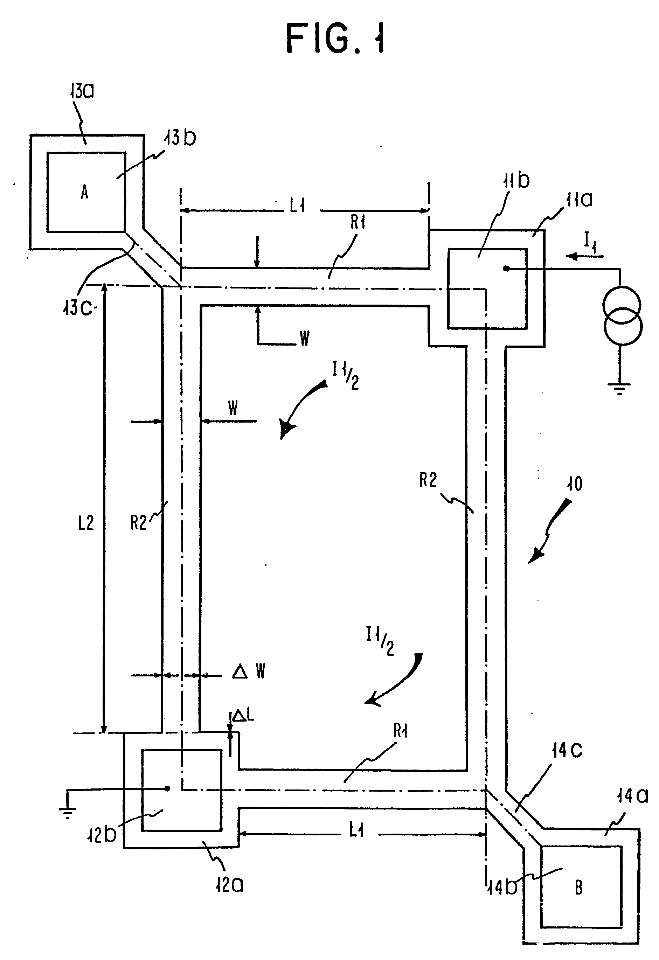

Sur la figure 1 on a représenté la topologie d'une première structure de test constituée par un premier pont de résistance 10. Cette figure peut être comprise comme montrant la forme des résistances implantées ou diffusées de type P dans un substrat de silicium de type N, ces résistances étant formées par l'introduction d'impuretés dopantes à travers une couche de masquage, par exemple en $SiO_2$ selon des techniques parfaitement connues et qui ne seront donc pas détaillées ici. Cette figure peut être aussi comprise comme montrant la forme de résistances déposées et gravées sur une couche isolante, et constituées par un matériau présentant une résistivité suffisante pour permettre une mesure du déséquilibre du pont par exemple du silicium polycristallin ou du métal. Dans un but de simplification de l'exposé on a choisi un pont de résistance symétrique ayant pratiquement la forme d'un rectangle.

Sur les parties élargies (ou régions de contact) qui terminent les extrémités des quatre résistances on distingue d'abord deux régions 11a et 12a, disposées selon une première diagonale dans l'alignement du corps des résistances R1 et R2 qui sont munies de contacts 11b et 12b, par exemple en aluminium. Le choix de cette forme de contact est préféré pour assurer que les lignes de courant soient parallèles au corps des résistances R1 et R2, et réduire les effets de résistance d'extrémité ($R_{END}$). Sur ces contacts on appliquera respectivement un courant $I_1$ et la masse. Deux autres régions 13a et 14a sont disposées selon la seconde diagonale, elles sont également munies de contacts 13b et 14b par exemple en aluminium sur lesquels on viendra mesurer la différence de potentiel aux bornes de ce pont.

Les régions de contact 13a et 14a sont de préférence alignées avec la seconde diagonale pour réduire les effets non désirés de résistances d'extrémité desdits contacts. La forme de ces régions de contact est de préférence celle représentée car, cette disposition facilite la mesure des potentiels (un faible courant traverse en fait les régions intermédiaires 13c et 14c). C'est donc sur les contacts 11b, 12b, ..., que l'on viendra appliquer les sondes de test (non représentées) pour expliquer ou mesurer des courants ou des potentiels.

Les résistances R1 et R2 présentent respectivement des longueurs différentes désignées L1 et L2, et une même largeur désignée W. La tolérance (ou erreur, ou variation) sur les dimensions de la largeur pour l'étape de lithographie est donnée par $\Delta W$.

On comprend en effet que les masques utilisés pour réaliser la configuration résistive désirée sur la tranche de silicium sont généralement fabriqués à partir d'une couche de chrome déposée sur une plaque de verre délimitée en utilisant les techniques connues de lithographie. La sur-exposition (ou la sous-exposition) de la résine lors de l'étape de délimitation crée des variations de la largeur de ligne dans la configuration du masque par rapport à la valeur nominale désirée par le concepteur de circuit. En outre le sur-décapage (ou le sous-décapage) du chrome ajoute lui aussi ses propres variations. Enfin il y a les variations provoquées par le sur-décapage (ou le sous-décapage) de la couche de masquage. C'est l'ensemble de ces variations qui provoque finalement cette erreur $\Delta W$ par rapport à la largeur nominale désirée (W).

On peut écrire les équations suivantes, sachant que les deux branches du pont ont la même résistance

$$V_A - V_B = \frac{I_1}{2} (R2 - R1) \, .$$

En posant $V_A - V_B = \Delta V_1$
on obtient

$$\Delta V_1 = \frac{I_1}{2} (R2 - R1) \, . \tag{1}$$

On peut écrire également

$$R1 = \rho_s \left( \frac{L_1 + \Delta L_1}{W + \Delta W} \right) + R_{END}$$

et

$$R2 = \rho_s \left( \frac{L_2 + \Delta L_2}{W + \Delta W} \right) + R_{END}$$

relations dans lesquelles $\rho_s$ est la résistivité surfacique du lit des résistances R1 et R2 et $\Delta L_1$, $\Delta L_2$ et $\Delta W$ sont les tolérances d'alignement sur les longueurs L1, L2 et la largeur W (identique pour les deux résistances), et enfin $R_{END}$ qui est la résistance d'extrémité entre le lit de la résistance et le contact. Pratiquement $\Delta L_1 \# \Delta L_2$, du moins en première approximation.

On forme R1-R2 et en tenant compte de (1) on trouve

$$\rho_s = \frac{2 \, \Delta V_1}{I_1 (L_2 - L_1)} (W + \Delta W) \, . \tag{2}$$

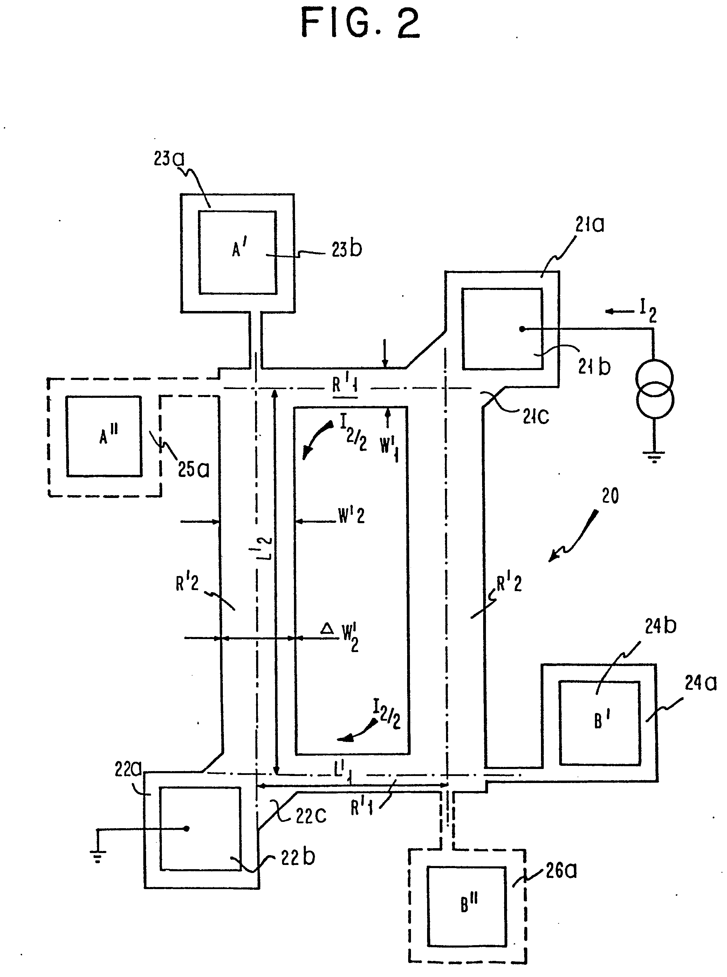

Cette relation est insuffisante pour fournir le rapport $\Delta W / W$ recherché, pour cela il faut utiliser une seconde structure de test également constituée par un second pont de résistance symétrique 20. Cette structure est représentée sur la figure 2. La topologie est assez voisine de celle représentée sur la figure 1. Elle comporte deux parties élargies ou régions de contact 21a, 22a, selon une première diagonale, munie de contacts 21b, 22b, par exemple en aluminium auxquels on applique respectivement un courant $I_2$ et la masse. Ces régions élargies ont, de préférence, une partie intermédiaire 21c, 22c, de la forme représentée, qui permet de réduire les effets des tolérances sur les longueurs et sur les largeurs ainsi que les effets de résistance d'extrémité. Les potentiels des régions 23a et 24a disposées sur l'autre diagonale, sont mesurés de façon similaire à partir des contacts 23b et 24b. On peut ajouter des régions 25a et 26a symétriquement aux régions 23a et 24a par rapport à la seconde diagonale dans un but d'approcher la différence de potentiel $\Delta V_2$ de façon plus précise en formant la moyenne

$$\Delta V_2 = \left( \frac{(V_{A'} - V_{B'}) + (V_{A''} - V_{B''})}{2} \right) \, .$$

En fait on peut écrire

$$\Delta V_2 = \frac{I_2}{2} (R_2' - R_1') \, . \tag{3}$$

On choisit pour simplifier $W'_1 = W$, $L'_2 = L_2$ et $L'_1 = L_1$.

Avec la topologie des régions intermédiaires retenue on peut estimer qu'il n'y a pas d'erreur $\Delta L$ due à la gravure et que les erreurs $\Delta W$ et $\Delta W'_2$ sont voisines, c'est-à-dire $\Delta W'_2 \# \Delta W$. Par ailleurs, on peut écrire :

$$R'_1 = \rho_s \frac{L_1}{W + \Delta W} + R_{END} = R_1$$

et

$$R'_2 = \rho_s \frac{L_2}{W'_2 + \Delta W} + R_{END}$$

en formant $R'_2 - R'_1$ et en combinant avec (3) on trouve

$$\rho_s \left[ \frac{L_2}{W'_2 + \Delta W} - \frac{L_1}{W + \Delta W} \right] = 2 \frac{\Delta V_2}{l_2}.$$

La relation ci-dessus peut s'écrire puisque

$$\frac{L_2}{W'_2} = \frac{L_1}{W}$$

$$2 \frac{\Delta V_2}{l_2} = \rho_s \frac{L_1}{W} \left[ \frac{1}{1 + \frac{\Delta W}{W'_2}} - \frac{1}{1 + \frac{\Delta W}{W}} \right]$$

$$2 \frac{\Delta V_2}{l_2} = \rho_s \frac{L_1}{W} \left[ \frac{W'_2(W + \Delta W) - W(W'_2 + \Delta W)}{(W'_2 + \Delta W)(W + \Delta W)} \right]$$

et en remplaçant $\rho_s$ par sa valeur donnée dans la relation (2)

$$= \frac{2 \Delta V_1}{l_1(L_2 - L_1)} \cdot \frac{(W + \Delta W) L_1}{W} \left[ \frac{W'_2(W + \Delta W) - W(W'_2 + \Delta W)}{(W'_2 + \Delta W)(W + \Delta W)} \right]$$

qui se simplifie

$$\frac{\Delta V_2}{l_2} = \frac{\Delta V_1}{l_1} \cdot \frac{L_1}{W(L_2 - L_1)} \left[ \frac{W'_2(W + \Delta W) - W(W'_2 + \Delta W)}{(W'_2 + \Delta W)} \right].$$

Si on pose

$$\frac{l_1}{l_2} = K'$$

et si le concepteur de circuit réalise la condition

$$\frac{L_2}{L_1} = \frac{W'_2}{W} = K$$

$$\frac{\Delta V_2}{\Delta V_1} = \frac{1}{(K)'} \cdot \frac{1}{W} \frac{W}{K - 1} \left[ \frac{\Delta W(K - 1)}{(KW - \Delta W)} \right] = \frac{1}{K'} \frac{\Delta W}{(KW + \Delta W)} \tag{4}$$

d'où

$$\frac{\Delta W}{W} = \frac{K.K'}{\frac{\Delta V_1}{\Delta V_2} - K'} \tag{5}$$

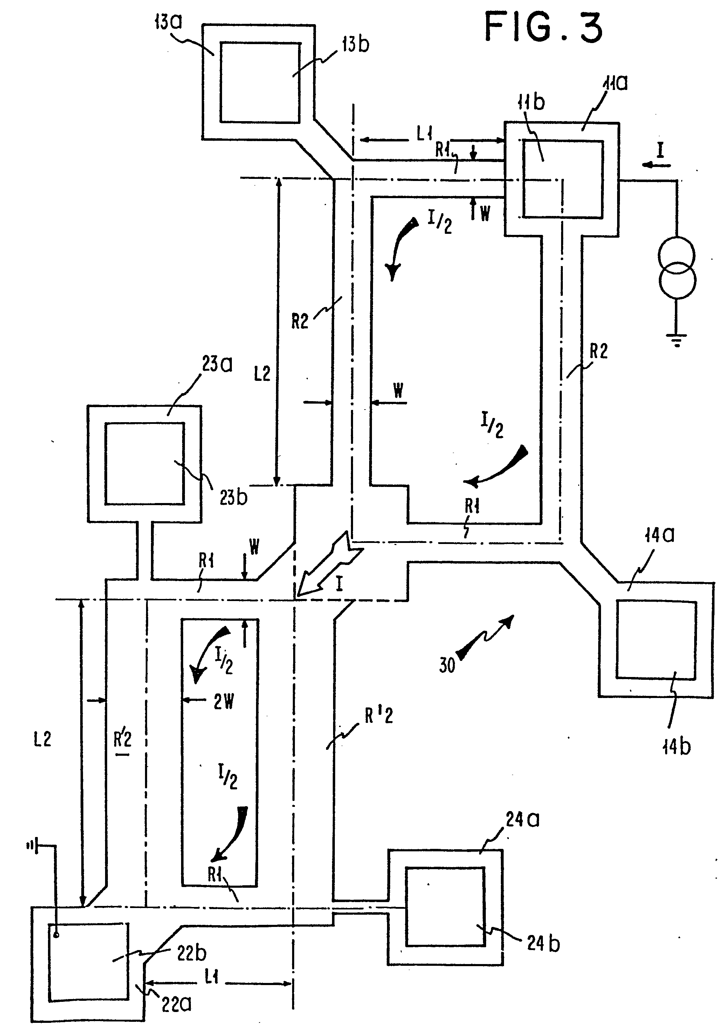

Le concepteur de circuit peut encore choisir des valeurs préférées pour les paramètres K et K'. Par exemple si $K' = 1$, c'est-à-dire $l_1 = l_2$, les deux structures peuvent très simplement se combiner en une seule structure 30 qui est représentée sur la figure 3 (les références identiques à celles des figures 1 et 2 ont été conservées). Enfin on a choisi $K = 2$, c'est-à-dire $W'_2 = 2W$ et $L_2 = 2L_1$, ce qui fait que la relation (5) devient

$$m = \frac{\Delta W}{W} = \frac{2\,\Delta V_2}{\Delta V_1 - \Delta V_2}.\qquad (6)$$

Ainsi avec la structure de test de la figure 3 on peut obtenir la tolérance sur la dimension d'image $(\Delta W/W)$ à partir de simples mesures électriques.

$$\Delta V_1 = V_A - V_B \quad \text{et} \quad \Delta V_2 = V'_A - V'_B.$$

Outre l'intérêt que cette mesure $(\Delta W/W)$ présente en soi pour la détermination de la tolérance d'image, facteur important pour l'appréciation de la précision de la gravure, elle peut être également utile pour permettre la détermination des tolérances de recouvrement de deux images superposées.

Les paramètres des différentes résistances constituant les ponts ont été choisis de façon à simplifier le calcul et permettre l'obtention de $\Delta W$ comme une fonction de $\Delta V_1$ et $\Delta V_2$. On doit cependant remarquer que le principe de l'invention reste applicable à des structures de ponts quelconques, auquel cas $\Delta W$ sera en outre fonction desdits paramètres ($L_1$, $W_1$, ...).

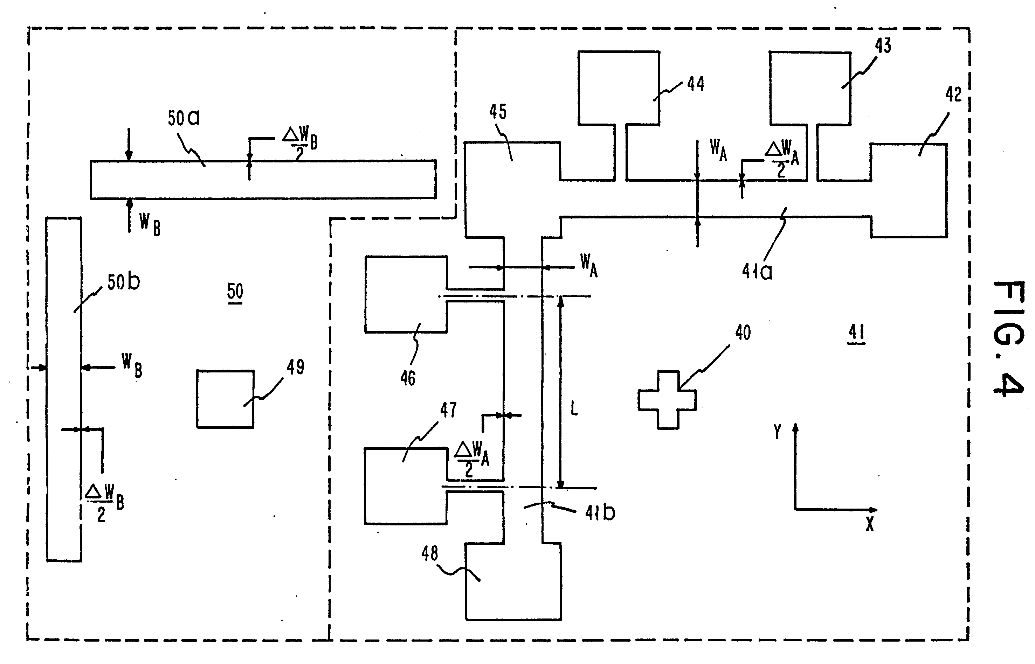

La figure 4 montre la topologie du masque correspondant à une structure de test qui permet la détermination électrique des tolérances de recouvrement. La topologie se caractérise par la présence d'une première image ou configuration 41 en forme de $\Gamma$ composée de deux parties 41a et 41b et de sept régions élargies ou régions de contact 42 à 48 qui permettront de procéder à différentes mesures électriques ultérieurement. Un marqueur 40 est associé à cette région. La topologie comprend également une seconde configuration 50 composée de deux parties distinctes 50a et 50b disposées en forme de $\Gamma$. Elle comporte également un marqueur 49. L'élément 50a sera aligné avec l'élément 41a mais légèrement décalé dans le sens de la direction des Y, quand les marqueurs 40 et 49 seront alignés et que les configurations 41 et 50 seront superposées. L'élément 50b est parallèle à l'élément 41b mais légèrement décalé selon la direction des X. Les deux configurations ne sont nécessaires que si l'on souhaite connaître la tolérance d'alignement selon les deux axes X et Y. La tranche de silicium qui est préalablement recouverte d'une couche isolante (ou résistive : métal ou polysilicium) et d'une couche de résine photosensible est exposée successivement à travers la configuration 41 puis la configuration 50. Ceci est obtenu simplement par la translation du masque portant ces configurations. Si on voulait inclure les tolérances propres au masque dans la mesure il faudrait utiliser deux masques séparés, l'un comportant la configuraton 50 et l'autre la configuration 41.

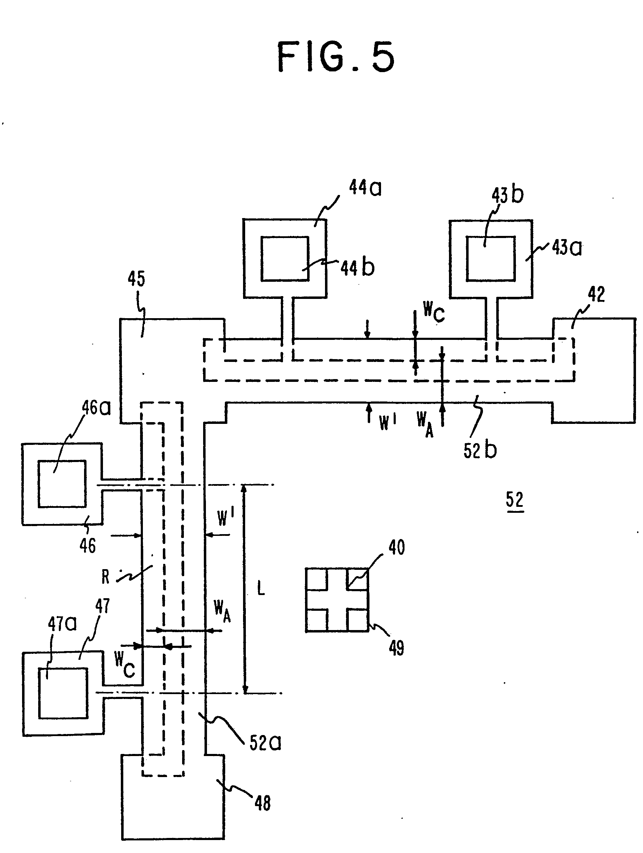

Ensuite de façon connue, on procède à la gravure puis à l'élimination de la résine. La configuration finale ouverte dans la couche isolante correspond à la superposition des deux configurations. Après implantation dans le substrat silicium d'une impureté dopante d'un type de conductivité opposé à celui du substrat on obtient une structure 52 composée de deux résistances 52a et 52b qui sont montrées sur la figure 5 en traits pleins. Dans le cas d'une couche résistive, ces résistances seraient obtenues directement par gravure sélective de la couche résistive. Les résistances 52a et 52b, servent à déterminer respectivement les tolérances d'alignement en X et en Y.

La largeur de ces résistances dépend des tolérances sur les dimensions des configurations 41 et 50 mais également du défaut d'alignement résultant de la superposition de ces deux configurations. Ce défaut d'alignement est exprimé par une tolérance dite d'alignement ou recouvrement $\Delta A$. Quand on connaît les tolérances de dimensions des images, on peut déduire $\Delta A$ de la façon suivante : la largeur finale $W'$ dépend des tolérances de dimension d'images sur les configurations 41 soit $(\Delta W_A)$ et 50 soit $(\Delta W_B)$ et de la tolérance d'alignement $(\Delta A)$ selon la relation

$$W' = W_A + W_C + \frac{\Delta W_A}{2} + \frac{\Delta W_B}{2} + \Delta A\qquad (7)$$

où $W_C$ représente sur la figure 5, l'accroissement de la largeur de la résistance, à noter que $\Delta A$, $\Delta W_A$ et $\Delta W_B$ peuvent être positifs ou négatifs.

Les tolérances de dimension des configurations 41 et 50 : $\Delta W_A$ et $\Delta W_B$ sont obtenues à partir des structures de test décrites à l'aide des figures 1 à 3. On admet que ce calcul est valable, les structures de test étant voisines sur la tranche de silicium. Elles sont en effet réalisées soit sur un bloc spécialisé (test site) soit sur le bord du bloc lui-même (kerf).

On a d'après (6)

$$\Delta W_A = m_A W_A \text{ et } \Delta W_B = m_B W_B$$

où $W_A$ et $W_B$ sont les largeurs qui sont spécifiées par le concepteur de circuit.

La relation (7) peut s'écrire :

6

$$\Delta A = W' - \left[ (W_A + W_C) + \frac{m_A}{2} W_A + \frac{m_B}{2} W_B \right]$$

et si on pose $W_A + W_C = W_D$

$$\Delta A = W' - W_D - \frac{m_A}{2} W_A - \frac{m_B}{2} W_B$$

à l'aide des contacts métalliques 46a, 47a disposés sur les régions élargies 46, 47 on peut mesurer la valeur des résistances

$$R = \rho_s \frac{L}{W'} ,$$

d'où

$$W' = \rho_s \frac{L}{R}$$

$\Delta A$ peut s'écrire :

$$\Delta A = \rho_s \frac{L}{R} - W_D - \frac{m_A}{2} W_A - \frac{m_B}{2} W_B \tag{8}$$

où

$m_A$ et $m_B$ caractérisent les tolérances de dimension,

$\rho_s$ est la résistance de feuille de la région implantée ou diffusée

$W_A$, $W_C$, $W_D$ et $L$ sont respectivement des largeurs et une longueur connues du concepteur.

On a donc immédiatement à partir d'une simple mesure de résistance et d'un calcul élémentaire la détermination de la tolérance (ou erreur) d'alignement.

Enfin pour une meilleure précision et si le nombre de points de test n'est pas un facteur limitatif, les résistances 52a et 52b peuvent être remplacées par des ponts de résistances, ceux-ci pouvant être orientés différemment selon qu'il s'agit d'une mesure de désalignement en X ou en Y.

**Revendications**

1. Procédé pour le contrôle de la tolérance relative de dimensions d'image $\Delta W/W$ d'une étape lithographique critique dans la séquence de traitement d'une tranche semi-conductrice à partir de seules mesures électriques, caractérisé en ce que l'on procède

(i) à la formation par l'intermédiaire d'une technique lithographique dans la tranche semi-conductrice ou sur la tranche semi-conductrice

— d'un premier pont de résistances (10) composé de deux premières branches identiques comportant chacune deux premières résistances ($R_1$, $R_2$) munies de régions de contact (IIa) ces premières résistances étant définies par leurs paramètres nominaux choisis de la manière suivante : $L_2 = 2 L_1$, $W_1 = W_2 = W$ ; $L_1$, $L_2$ et $W_1$, $W_2$ étant respectivement les longueurs et les largeurs des deux premières résistances ;

— d'un second pont de résistances (20) composé de deux secondes branches identiques comportant chacune deux secondes résistances ($R'_1$, $R'_2$) munies de régions de contact (21a), ces secondes résistances étant définies par leurs paramètres nominaux choisis de la manière suivante : $L'_1 = L_1$, $W'_1 = W$ ; $L'_2 = L_2$, $W'_2 = 2 W$ ; $L'_1$, $L'_2$ et $W'_1$, $W'_2$ étant respectivement les longueurs et les largeurs des deux secondes résistances ;

(ii) à l'application d'un premier courant $I_1$ et d'un second courant $I_2$ selon une première diagonale respectivement du premier et du second pont de résistances ;

(iii) à la mesure des tensions $\Delta V_1$ et $\Delta V_2$ selon la seconde diagonale pour chaque pont de résistances et

(iv) au calcul de la tolérance relative de dimensions d'image $\Delta W/W$ par la relation

$$\frac{\Delta W}{W} = \frac{2 K'}{\dfrac{\Delta V_1}{\Delta V_2} - K'} \quad \text{avec} \quad K' = \frac{I_1}{I_2}$$

$\Delta V_1$ et $\Delta V_2$ étant les tensions, selon la seconde diagonale, respectivement du premier et du second pont de résistances.

2. Procédé selon la revendication 1 caractérisé en ce que $I_1 = I_2$.

3. Procédé selon la revendication 2 caractérisé en ce que lesdits ponts sont disposés en série pour former une structure de test unique.

4. Procédé pour le contrôle électrique de la tolérance absolue d'alignement $\Delta A$ de deux images superposées formées par l'intermédiaire d'une technique lithographique sur une tranche semi-conductrice caractérisé en ce qu'on procède aux étapes suivantes :

— formation dans la tranche semi-conductrice ou sur la tranche semi-conductrice d'au moins un premier élément résistif à l'aide d'une première étape lithographique selon une première configuration désirée (41a) et une première direction (X) préférée avec des premiers paramètres nominaux choisis ($W_A$)

— modification du premier élément résistif à l'aide d'une seconde étape lithographique selon une seconde configuration désirée (50a), la modification consistant en la superposition d'un second élément résistif avec la même direction du premier élément résistif ; ce second élément résistif ayant des seconds paramètres nominaux choisis ($W_B$), ladite superposition fournissant ainsi un élément résistif final ayant des troisièmes paramètres nominaux choisis ($W'$) et

— calcul de la tolérance absolue d'alignement $\Delta A$ à l'aide de la relation

$$W' = W_A + W_C + \frac{\Delta W_A}{2} + \frac{\Delta W_B}{2} + \Delta A$$

$W'$ étant la largeur de l'élément résistif final,

$W_A$ la largeur du premier élément résistif,

$W_C$ l'accroissement de la largeur du premier élément résistif dû à ladite superposition,

$\Delta W_A$, $\Delta W_B$ les tolérances absolues de dimensions d'image respectivement du premier et du second élément résistif ; dans laquelle relation les tolérances absolues de dimensions d'image $\Delta W_A$, $\Delta W_B$ du premier et du second élément résistif sont déterminées par application du procédé tel que défini par l'une quelconque des revendications ci-dessus.

5. Procédé selon la revendication 4 caractérisé en ce qu'à la première (41a) et seconde (50a) configuration selon la première direction (X) on ajoute une troisième (41b) et une quatrième (50b) configuration selon une deuxième direction (Y) perpendiculaire à la première direction.

6. Procédé selon la revendication 4 caractérisé en ce que lesdites configurations sont des ponts de résistances.

7. Procédé selon la revendication 6 caractérisé en ce que toutes lesdites configurations sont disposées sur un même masque, les deux étapes lithographiques s'obtenant par translation dudit masque.

8. Procédé selon l'une des revendications 4 à 7 caractérisé en ce que l'étape de formation de l'élément résistif final comprend une étape d'introduction d'impuretés dopantes dans ladite tranche d'un type de conductivité opposé à celui de la tranche semi-conductrice.

**Claims**

1. A method for minitoring the image size tolerances DW/W during a critical lithographic step in the processing of a semiconductor wafer from electric measurements only, characterized in that it includes the steps of :

(i) lithographically forming in (or on) the semiconductor wafer

— a first resistor bridge (10) comprised of two first identical branches, each one being provided with two first resistors (R1, R2) provided with contact regions (IIa), said first resistors being defined by their nominal parameters chosen as follows : $L_2 = 2 L_1$, $W_1 = W_2 = W$, $L_1$, $L_2$ and $W_1$, $W_2$ respectively being the lengts and widths of said first two resistors.

— a second resistor bridge (20) comprised of two second identical branches, each one being provided with two second resistors ($R'_1$, $R'_2$) provided with contact regions (21a), said second resistors being defined by their nominal parameters chosen as follows : $L'_1 = L_1$, $W'_1 = W$, $L'_2 = L_2$, $W'_2 = 2 W$, $L'_1$, $L'_2$ and $W'1$, $W'_2$ respectively being the lengths and widths of said second tow resistors.

(ii) injecting a first current $I_1$ and a second current $I'_2$ across a first diagonal in each resistor bridge.

(iii) measuring voltages $\Delta V_1$ and $\Delta V_2$ across the second diagonal in each resistor bridge and

(iv) calculating the relative image size tolerances $\Delta W/W$ by using using the following relation :

$$\frac{\Delta W}{W} = \frac{2 K'}{\dfrac{\Delta V_1}{\Delta V_2} - K'} \quad \text{with} \quad K' = \frac{I_1}{I_2}$$

$\Delta V_1$ and $\Delta V_2$ respectively being the voltages across the second diagonal of said first and second resistor bridges.

2. A method according to claim 1 characterized in that $l_1 = l'_2$.

3. A method according to claim 2 characterized in that said bridges are arranged in series for forming a single test structure.

4. A method for electrically monitoring the absolute alignment tolerance $\Delta A$ for two superimposes lithographically formed images on a semiconductor wafer, characterized in that it includes the steps of :

— forming in (or on) the semiconductor wafer at least a first resistive element by means of a first lithographic step, exhibiting a first desired configuration (41a) and a first preferred orientation (X) and having first chosen nominal parameters (WA),

— modifying said first resistive element by means of a second lithographic step according to a second desired configuration (50a), the modification consisting in superimposing a second resistive element exhibiting the same orientation as first resistive element, said second resistive element having second chosen nominal parameters (WB), said superimposition providing a final resistive element having third chosen nominal parameters (W') and

— calculating the absolute alignment tolerance $\Delta A$ by means of the relation

$$W' = W_A + W_C + \frac{\Delta W_A}{2} + \frac{\Delta W_B}{2} + \Delta A$$

W' being the width of the final resistive element,

WA being the width of the first resistive element,

WC being the extension of the width of said first resistive element due to said superimposition,

$\Delta W_A$, $\Delta W_B$ respectively being the absolute image size tolerances of the first and second resistive element, in which relation the absolute image size tolerances $\Delta W_A$, $\Delta W_B$ of the first and second resistive elements are determined by implementing the method as defined in any one of the preceding claims,

5. A method according to claim 4, characterized in that there is added to the first and second configurations (41a, 50a) oriented along the first direction (X), a third and a fourth configurations (41b, 50b) oriented along a second direction (Y) perpendicular to the first direction.

6. A method according to claim 4, characterized in that said configurations are in effect resistor bridges.

7. A method according to claim 6, characterized in that all of said configurations are located on the same mash, with the two lithographic steps being performed by translating said mash.

8. A method according to any one of claims 4 to 7, characterized in that the step of forming the final resistive element includes the step of introducing in said wafer doping impurities of a type of conductivity opposite that of the semiconductor wafer.

**Ansprüche**

1. Verfahren zum Pruefen der relativen Zuverlaessigkeitsgrenzen betreffs der Bildabmessungen $\Delta W/W$ bei einem kritischen lithographischen Schritt des Herstellungsprozesses einer halbleitenden Scheibe nur anhand elektrischer Messungen, dadurch gekennzeichnet, dass der Herstellungsprozess wie folgt ablaueft :

(i) Mittels einer lithographischen Technik werden in oder auf der halbleitenden Scheibe

— eine erste Widerstandsbruecke (10), die aus zwei ersten aehnlichen jeweils zwei erste mit Kontaktbereichen (11a) versehene Widerstaende ($R_1$, $R_2$) aufweisenden Zweigen besteht, wobei diese ersten Widerstaende durch ihre wie folgt ausgewaehlten Nennkennwerte festgelegt sind : $L_2 = 2 L_1$, $W_1 = W_2 = W$ ; wobei $L_1$, $L_2$ und $W_1$, $W_2$ jeweils die Laenge und die Breite der zwei ersten Widerstaende meinen,

— eine zweite Widerstandsbruecke (20), die aus zwei zweiten aehnlichen jeweils zwei zweite mit Kontaktbereichen (21a) versehene Widerstaende ($R'_1$, $R'_2$) aufweisenden Zweigen besteht, wobei diese zweiten Widerstaende durch ihre wie folgt ausgewaehlten Nennkennwerte festgelegt sind : $L'_1 = L_1$, $W'_1 = W$ ; $L'_2 = L_2$, $W'_2 = 2 W$ ; wobei $L'_1$, $L'_2$ und $W'_1$, $W'_2$ jeweils die Laenge und die Breite der zwei zweiten Widerstaende meinen, gebildet.

(ii) Zufuehrung eines ersten Stromes $l_1$ und eines zweiten Stromes $l'_2$ via eine erste Diagonale jeweils der ersten und der zweiten Widerstandsbruecke.

(iii) Messung der Spannungen $\Delta V_1$ und $\Delta V_2$ der zweiten Diagonale entsprechend bei jeder Widerstandsbruecke.

(iv) Berechnung der relativen Zuverlaessigkeitsgrenzen betreffs der Bildabmessungen $\Delta W/W$ nach dem folgenden Verhaeltnis :

$$\frac{\Delta W}{W} = \frac{2 K'}{\dfrac{\Delta V_1}{\Delta V_2} - K'} \quad \text{mit} \quad K' = \frac{l_1}{l_2}$$

wo $\Delta V_1$ und $\Delta V_2$ die jeweiligen via die zweite Diagonale zugefuehrten Spannungen der ersten und der zweiten Widerstandsbruecke.

2. Verfahren nach Anspruch 1, dadurch gekennzeichnet, dass $I_1 = I_2$.

3. Verfahren nach Anspruch 2, dadurch gekennzeichnet, dass die Widerstandsbruecke so hintereinandergeschaltet sind, dass es zur Entstehung einer einzelnen Pruefstruktur veranlasst.

4. Verfahren zur elektrischen Pruefung der absoluten Zuverlaessigkeitsgrenzen betreffs der Ausrichtung $\Delta A$ zwei ueberlagerter nach einer lithographischen Technik auf einer Siliziumscheibe gebildeter Bilder, dadurch gekennzeichnet, dass es folgende Vorgaenge aufweist :

— Bildung mindestens eines ersten Widerstandselements in oder auf der Siliziumscheibe mit Hilfe eines ersten lithographischen Vorgangs jenach einem ersten gewuenschten Muster (41a) und einer ersten bevorzugten Richtung (X) und unter Anwendung erster ausgewaehlter Nennkennwerte ($W_A$).

— Aenderung eines ersten Widerstandselements mit Hilfe eines zweiten lithographischen Vorgangs jenach einem zweiten gewuenschten Muster (50a), wo die Aenderung in der Ueberlagerung eines zweiten Widerstandselements jenach der selben Richtung als der des ersten Widerstandselements besteht ; wobei das zweite Widerstandselement zweite ausgewaehlte Nennkennwerte ($W_B$) und das endgueltige Widerstandselement dritte ausgewaehlte Nennkennwerte ($W'$) aufweisen,

— Berechnung der absoluten Zuverlaessigkeitsgrenzen betreffs der Ausrichtung $\Delta A$ nach dem folgenden Verhaeltnis :

$$W' = W_A + W_C + \frac{\Delta W_A}{2} + \frac{\Delta W_B}{2} + \Delta A$$

wo

$W'$ die Breite des endgueltigen Widerstandselements ist,

$W_A$ die Breite des ersten Widerstandselements ist,

$W_C$ der auf die Ueberlagerung zurueckzufuehrende Zuwachs der Breite des ersten Widerstandselements ist,

$\Delta W_A$, $\Delta W_B$ die absoluten Zuverlaessigkeitsgrenzen betreffs der jeweiligen Bildabmessungen des ersten und des zweiten Widerstandselements sind, wo das angewendete Verhaeltnis diejenige absoluten Zuverlaesigkeitsgrenzen betreffs der jeweiligen Bildabmessungen $\Delta W_A$ und $\Delta W_B$ des ersten und zweiten Widerstandselemente benutzt, die durch Durchfuerung des Verfahrens nach einem der obengenannten Ansprueche festgelegt sind.

5. Verfahren nach Anspruch 4, dadurch gekennzeichnet, dass dem ersten (41a) und dem zweiten Muster (50a) jenach der ersten Richtung (X) ein dritter (41b) und ein zweiter (50b) Muster jenach einer zweiten zu der ersten Richtung senkrechten Richtung (Y) hinzugefuegt sind.

6. Verfahren nach Anspruch 4, dadurch gekennzeichnet, dass die Muster Widerstandsbruecke sind.

7. Verfahren nach Anspruch 6, dadurch gekennzeichnet, dass die gesamten Muster auf einer einzigen Masque angebracht sind, wobei die zwei lithographischen Vorgaenge mittels Verlegung der Maske durchgefuehrt sind.

8. Verfahren nach einem der Ansprueche 4 bis 7, dadurch gekennzeichnet, dass der Vorgang zur Entstehung des Widerstandselements einen Schritt der Einfuehrung von dotierenden Stoerstellen in der Siliziumscheibe einschliesst, wo die dotierenden Stoerstellen einen zu dem Leitungstyp der halbleitenden Scheibe entgegengesetzten Leitungstyp aufweisen.

# FIG. 1

# FIG. 2

FIG.3

# FIG. 4

# FIG. 5